# EUROPÄISCHE PATENTSCHRIFT

(11) **EP 2 040 520 B1**
(45) Veröffentlichungstag und Bekanntmachung des Hinweises auf die Patenterteilung: **11.05.2011**
(21) Anmeldenummer: 07023617.9
(22) Anmeldetag: 06.12.2007
(51) Int. Cl.: H05K 1/03

(54) **Leiterkarte und Verfahren zum Erhöhen der Widerstandsfähigkeit einer Leiterkarte gegen eine Bildung von leitfähigen Filamenten**
Circuit board and method for increasing the resistance capacity of a circuit board against formation of conductive filaments
Carte de circuits imprimés et procédé destinés à l'augmentation de la résistance d'une carte de circuits imprimés contre une formation de filaments conducteurs

(30) Priorität: 18.09.2007 CH 14542007
(43) Veröffentlichungstag der Anmeldung: 25.03.2009
(73) Patentinhaber: CT-Concept Holding AG, 2504 Biel (CH)
(72) Erfinder: Pawel, Sascha, CH-2502 Biel (CH)
(74) Vertreter: Fischer, Britta Ruth

(56) Entgegenhaltungen:
- EP-A- 1 653 789
- US-A- 5 981 880
- US-A1- 2002 123 285

## Beschreibung

Die Erfindung betrifft eine Leiterkarte gemäss Oberbegriff des Anspruchs 1 und ein Verfahren zum Erhöhen der Widerstandsfähigkeit einer Leiterkarte gegen eine Bildung von leitfähigen Filamenten gemäss Oberbegriff des Anspruchs 10.

Leiterkarten bestehen üblicherweise zum überwiegenden Teil aus glasfaserverstärkten Kunstharzen. Die glasfaserverstärkten Kunstharze bilden eine Trägerstruktur auf die planare Leitbahnen aufgebracht werden. Dieser Aufbau wiederholt sich in mehreren, übereinander liegenden Schichten. Zur Verbindung von in unterschiedlichen Schichten angeordneten Leitbahnen werden Kontaktlöcher eingesetzt, die entweder einen Teil der Schichten oder die gesamte Leiterkarte durchstossen.

Innerhalb einer Leiterkarte kann es zum Wachstum von leitfähigen Filamenten (conductive anodic filament, CAF) kommen. Ein leitfähiges Filament besteht typischerweise aus abgelagerten Metallverbindungen bzw. abgelagertem Metall und seine Länge verkürzt eine verbleibende Strecke von einer ersten Leiterstruktur (z.B. einer Leitbahn, einem Kontaktloch) auf einem ersten elektrischen Potential zu einer zweiten, nächstgelegenen Leiterstruktur auf einem zweiten elektrischen Potential.

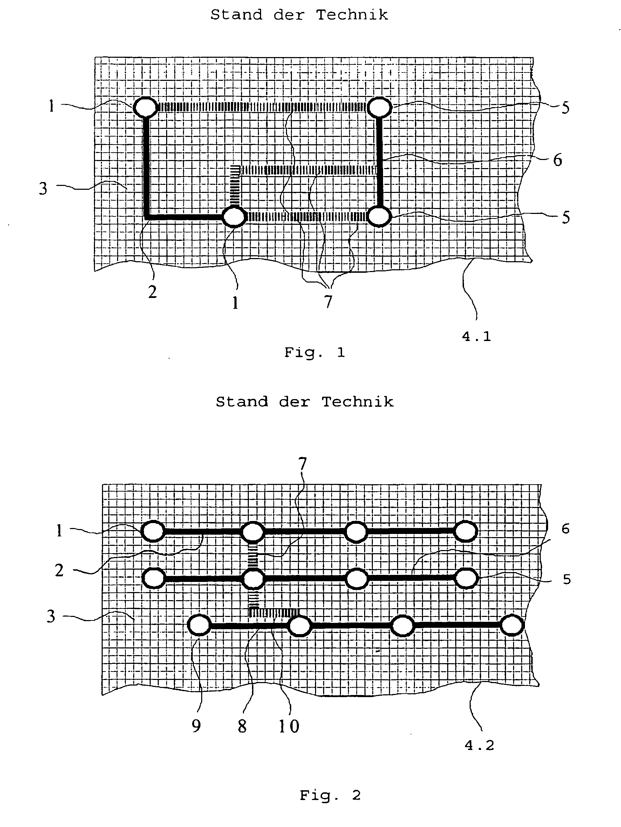

Dies ist in Fig. 1 schematisch dargestellt. Fig. 1 zeigt einen Teilausschnitt einer Leiterkarte 4.1 aus glasfaserverstärktem Kunstharz 3 (Kunstharz-Glasfasergewebe), die eine erste Leitbahn 2 mit Kontaktlöchern 1 auf einem ersten Potential und eine zweite Leitbahn 6 mit Kontaktlöchern 5 auf einem zweiten Potential aufweist. Von der ersten Leitbahn 2 und insbesondere von deren Kontaktlöchern 1 können leitfähige Filamente 7 in Richtung auf die zweite Leitbahn 6 bzw. deren Kontaktlöcher 5 wachsen oder vice versa je nach Richtung des Potentialgefälles. Sobald ein oder die Filamente 7 die zweite Leitbahn 6 oder eines von deren Kontaktlöchern 5 erreicht, führt dies zu einer starken Beeinflussung der Isolation zwischen den beiden durch die Leitbahnen 2, 6 und deren Kontaktlöcher 1, 5 gebildeten Leiterstrukturen, was ein Funktionsversagen der Leiterkarte 4.1 zur Folge haben kann.

Die leitfähigen Filamente breiten sich typischerweise, aber nicht ausschliesslich, entlang einzelner Glasfasern oder Glasfaserbündel aus (vgl. D. J. Lando, J. P. Mitchell, T. L. Welsher, "Conductive Anodic Filaments in Reinforced Polymeric Dielectrics: Formation and Prevention", International Reliability Physics Symposium, 1975, pp. 51-63, K. Rogers, C. Hillmann, M. Pecht, "Conductive Filament Formation Failure in a Printed Circuit Board", Circuit World, Vol. 25, 1999, pp. 6-8, A. Brewin, L. Zou, C. Hunt, "Susceptibility of Glass-Reinforced Epoxy Laminates to Conductive Anodic Filamentation", National Physical Laboratory (NPL) Report MATC(A)155, Sept. 2004, ISSN 1473 2734).

Das hier als "Filament" bezeichnete Phänomen wird dabei von rein an der Oberfläche einer Leiterkarte auftretenden Phänomenen unterschieden (B. Rudra, M. Pecht, D. Jennings, "Assessing Time-to-Failure due to Conductive Filament Formation in Multilayer Organic Laminates", IEEE Transactions on Components, Packaging and Manufacturing Techniques - Part B, Vol. 17, No. 3, August 1994, pp. 269-276, A. Brewin, L. Zou, C. Hunt, "Susceptibility of Glass-Reinforced Epoxy Laminates to Conductive Anodic Filamentation", National Physical Laboratory (NPL) Report MATC(A)155, Sept. 2004, ISSN 1473 2734). So handelt es sich insbesondere nicht um das rein chemische Anlösen von Leitbahnmetall (so genanntes tarnish creepage) und ebenfalls nicht um so genanntes Whisker-Wachstum, welches primär von mechanischer Belastung hervorgerufen wird.

Der Bildungs- bzw. Wachstumsmechanismus der leitfähigen Filamente wird als elektrochemische Reaktion verstanden, die über Wasseranteile im Kunstharz und/oder im Besonderen über adsorbierte Wasserschichten auf der Oberfläche der Glasfasern vermittelt wird (B. Rudra, M. Pecht, D. Jennings, "Assessing Time-to-Failure due to Conductive Filament Formation in Multilayer Organic Laminates", IEEE Transactions on Components, Packaging and Manufacturing Techniques - Part B, Vol. 17, No. 3, August 1994, pp. 269-276). Der Bildungs- bzw. Wachstumsmechanismus kann als elektrolytische Korrosion angesehen werden und wird daher durch hohe elektrische Feldstärken begünstigt. Es ist ferner bekannt, dass Bestandteile von chemischen Hilfs- und Funktionsstoffen für die Leiterkartenherstellung die Bildung der Filamente begünstigen können (W. J. Ready, L. J. Turbini, "A Combination of Hourly Versus Daily Testing Methods for Evaluating the Reliability of Water Soluble Fluxes", IEEE Trans. On Advanced Packaging, Vol. 23, No. 2, May 2000, W. J. Ready, L. J. Turbini, S. R. Stock, B. A. Smith, "Conductive Anodic Filament Enhancement in the Presence of a Polyglycol - Containing Flux", IEEE Reliability Physics Symosium, 1996, pp. 267-273). Unterschiedliche chemische Zusammensetzungen der Kunstharz-Komponente der Leiterkarte können zu einer Beeinflussung der Wachstumsrate der Filamente führen.

Es wird im Allgemeinen davon ausgegangen, dass es sich bei der Bildung der leitfähigen Filamente im Wesentlichen um einen zweistufigen Prozess handelt: In einer ersten Phase verändert sich die Grenzfläche zwischen den verstärkenden Glasfasern der Leiterkarte und dem die Glasfasern umgebenden Kunstharz. Die Veränderung ist dergestalt, dass die Bindung zwischen Kunstharz und Glasfaser vermindert wird und Wasser sowie ionische Reaktionsbestandteile auf der Glasfaseroberfläche als wässrige Lösung angelagert werden können. Einen Sonderfall bildet hierbei die Anwesenheit hohler Glasfasern im Leiterkartenmaterial. Hohle Glasfasern weisen in ihrem Inneren kein Kunstharz auf. Daher ist bei ihnen die erste Phase gleichsam von vorneherein abgeschlossen (M. Pecht, C. Hillman, K. Rogers, D. Jennings, "Conductive Filament Formation: A Potential Reliability Issue in Laminated Printed Circuit Cards with Hollow Fibers", IEEE Trans. On Electronics Packaging Manufacturing, Vol. 22, No. 1, Jan. 1999, pp. 80-84, K. Rogers, C. Hillmann, M. Pecht, "Hollow Fibers Can Accelerate Conductive Filament Formation", ASM International Practical Failure Analysis, Vol. 1, Issue 4, August 2001, pp.57-60). Insbesondere wenn ein Kontaktloch eine solche hohle Glasfaser durchschneidet, ist die Bildung leitfähiger Filamente hoch wahrscheinlich.

In einer zweiten Phase findet ein Transport von Metall bzw. Metall-Ionen (im Allgemeinen von Kupfersalzen, gegebenenfalls von Kupferkomplexen, bei Kupfer enthaltenden Leitbahnen bzw. Kontaktlöchern) zwischen zwei Punkten unterschiedlichen Potentials statt, beispielsweise zwischen zwei Leitbahnen bzw. deren Kontaktlöchern. Dieser Metalltransport bewirkt die Bildung des leitfähigen Filaments. Darüber hinaus wirkt ein Gradient des pH-Werts der sich an den Glasfasern anlagernden wässrigen Lösung vermittelnd für den Prozess des Metalltransports (D. J. Lando, J. P. Mitchell, T. L. Welsher, "Conductive Anodic Filaments in Reinforced Polymeric Dielectrics: Formation and Prevention", International Reliability Physics Symposium, 1975, pp. 51-63, B. Rudra, D. Jennings, "Tutorial Failure-Mechanism Models for Conductive-Filament Formation", IEEE Transactions on Reliability, Vol. 43., No. 3, Sept. 1994, pp. 354-360, A. Brewin, L. Zou, C. Hunt, "Susceptibility of Glass-Reinforced Epoxy Laminates to Conductive Anodic Filamentation", National Physical Laboratory (NPL) Report MATC(A)155, Sept. 2004, ISSN 1473 2734).

Es sind mehrere konzeptionell unterschiedliche Lösungswege bekannt, um dem Phänomen der Bildung leitfähiger Filamente entgegenzuwirken:

Durch eine geeignete Behandlung und/oder Beschichtung der Oberfläche der Glasfasern des Leiterkartenmaterials kann die Verbindungsstärke zwischen Kunstharz und Glasfaser erhöht werden, sodass die oben beschriebene erste Phase der Filamentbildung behindert werden kann (vgl. WO0224592, JP9012343, US2007141268, US5585147, JP7279055).

Bei einer bekannten Möglichkeit, die Wachstumsrate bzw. -geschwindigkeit der Filamente zu vermindern, wird der Feuchtegehalt der gesamten Leiterkarte gesenkt bzw. die neuerliche Feuchteaufnahme aus der Umgebung durch die Leiterkarte behindert (vgl. M. G. Pecht, H. Ardebili, A. A. Shukla, J. K. Hagge, D. Jennings, "Moisture Ingress Into Organic Laminates", IEEE Trans. on Components and Packaging Technology, Vol. 22, No. 1, Mar. 1999, pp. 104-110, US6944946, JP2005101362).

Ferner existieren Leiterkartenmaterialien mit einer reduzierten Anzahl von hohlen Glasfasern (JP2004115368).

Einige bekannte Lösungen arbeiten mit einer speziell angepassten chemischen Zusammensetzung der für die Leiterkarten verwendeten Kunstharze sowie mit einer speziellen Verarbeitung der Kunstharze (vgl. B.-C. Wu, M. Pecht, D. Jennings, "Conductive Filament Formation in Printed Wiring Boards", IEEE Interbational Electronics Manufacturing Technology Symposium, 1992, pp. 74-79, M. G. Pecht, H. Ardebili, A. A. Shukla, J. K. Hagge, D. Jennings, "Moisture Ingress Into Organic Laminates", IEEE Trans. on Components and Packaging Technology, Vol. 22, No. 1, Mar. 1999, pp. 104-110, K. Nawa, M. Ohkita, "Reliability of the Laminate from Advanced COPNA-Resin/E-Glass Fabrics System", IEEE Trans. on Components and Packaging Technology-PartB, Vol. 20, No. 1, Feb. 1997, pp. 78-86, TW591989B, JP2000183470, JP2004149577, JP8151458).

Ferner bestehen Ansätze, über die Vermeidung bestimmter reaktionsvermittelnder Stoffe, insbesondere von Halogen-Verbindungen, die Rate zu vermindern, mit welcher die Metall-Ionen in Lösung gehen (TW261603B). Die elektrolytische Reaktion der Filamentbildung hängt von der Rate ab, mit welcher die Metall-Ionen in Lösung gehen.

Aus JP5140419 ist es bekannt, die reaktionsfähige Menge der Metall-Ionen in Lösung durch Ionentauscher innerhalb der Kunstharzmatrix der Leiterkarte zu vermindern.

Die erste Phase bei der Bildung eines leitfähigen Filaments, in der sich die Bindung zwischen Glasfaser und die Glasfaser umgebendem Kunstharz herabsetzt, tritt umso ausgeprägter auf, je mehr natürliche Schwachstellen in dieser Bindung von vorneherein vorhanden sind. In JP2006232951 ist ein Verfahren zur Reduzierung derartiger Schwachstellen beschrieben.

Kontaktlöcher, die durch metallisierte Bohrungen im Leiterkartenmaterial gebildet sind, sind üblicherweise besonders anfällig für die Bildung von leitfähigen Filamenten. In JP2001177247 ist ein Kontaktlochaufbau beschrieben, der zu einer Verzögerung der ersten Phase bei der Bildung von leitfähigen Filamenten führen soll. Dabei wird das Kontaktloch nach dem Bohren und vor der Metallisierung mit einem geeigneten Material beschichtet. Infolgedessen kommen die beim Bohren potentiell geschädigten Glasfaser-Kunstharz-Bereiche nicht in Kontakt mit dem Metall, sodass der Bildung einer elektrochemischen Zelle und hierdurch eines leitfähigen Filaments entgegengewirkt wird.

In herkömmlicher Weise sind die Glasfasern bzw. Glasfaserbündel des Leiterkartenmaterials in einem Raster bzw. einer Matrix jeweils rechtwinklig zueinander verwoben. Das Filamentwachstum erfolgt typischerweise entlang der Glasfasern. Zur Vermeidung der Beeinträchtigung der Isolation zwischen zwei Leiterstrukturen unterschiedlichen elektrischen Potentials kann die zweite Leiterstruktur bezüglich des orthogonalen Rasters verschoben werden. Dies ist in Fig. 2 schematisch dargestellt, wobei die Begriffe "horizontal" und "vertikal" sich in Bezug auf die Fig. 2 auf deren Bildebene beziehen. Fig. 2 zeigt einen Teilausschnitt einer Leiterkarte 4.2 mit einem Kunstharz-Glasfasergewebe 3 und mit einer ersten Leitbahn 2 mit Kontaktlöchern 1 auf einem ersten Potential und einer zweiten Leitbahn 6 mit Kontaktlöchern 5 auf einem zweiten Potential, wobei die Leitbahn 6 mit den Kontaktlöchern 5 parallel zu der Leitbahn 2 mit den Kontaktlöchern 1 verläuft und horizontal auf diese ausgerichtet ist. Das heisst, die Kontaktlöcher 1, 5 und die Leitbahnen 2, 6 sind nicht horizontal zueinander verschoben. Die Leitbahnen 2, 6 und die Kontaktlöcher 1, 5 sind ferner an der durch die verwobenen Glasfasern der Leiterkarte 4.2 gebildeten Matrix (angedeutet durch die karierte Darstellung der Leiterkarte 4.2) ausgerichtet. Es ist ein leitfähiges Filament 7 dargestellt, das horizontal aufeinander ausgerichtete Kontaktlöcher 1, 5 miteinander verbindet, wobei die jeweiligen Radien der Kontaktlöcher 1, 5 die Länge des Filaments 7 verkürzen. Dargestellt ist ein sehr wahrscheinlicher Verlauf eines Filaments 7.

Die Leiterkarte 4.2 weist eine dritte Leitbahn 8 mit Kontaktlöchern 9 auf einem dritten Potential auf, die gegenüber den Leitbahnen 2, 6 bzw. deren Kontaktlöchern 1, 5 horizontal verschoben ist. Die Kontaktlöcher 9 der dritten Leitbahn 8 sind nicht horizontal mit den Kontaktlöchern 1, 5 der Leitbahnen 2, 6 ausgerichtet, sondern befinden sich horizontal gesehen zwischen zwei Kontaktlöchern 1 bzw. 5. Die Leitbahn 8 ist ebenfalls nicht auf die Leitbahnen 2, 6 ausgerichtet. Die Kontaktlöcher 9 sind gegenüber den Kontaktlöchern 6 um 45° verschoben, wobei sich auf das durch die Glasfasermatrix gebildete Koordinatensystem bezogen wird. Die Verschiebung der dritten Leitbahn 8 und von deren Kontaktlöchern 9 gegenüber den Leitbahnen 2, 6 und deren Kontaktlöchern 1, 5 resultiert in einem längeren Filament 10, wobei wiederum ein sehr wahrscheinlicher Verlauf eines sich bildenden Filaments 10 dargestellt ist. Der Pfad der Filamentbildung wird also durch die Verschiebung länger, sodass die Isolation zwischen der Leitbahn 8 mit den Kontaktlöchern 9 und den weiteren Leiterstrukturen länger durch die Filamentbildung unbeeinträchtigt bleibt.

Es ist bei Leiterkarten, die für höhere Spannungen geeignet sein sollen, üblich, die isolierenden Kunstharz-Glasfasergewebe-Schichten zwischen Leitbahnebenen unterschiedlichen elektrischen Potentials mehrfach auszulegen. Hierdurch wird der Einfluss von Schwachstellen in jeder einzelnen der Kunstharz-Glasfasergewebe-Schichten auf die Gesamtisolation reduziert.

Darüber hinaus werden zu isolierende Leiterstrukturen, wie beispielsweise Leitbahnen, häufig in unterschiedlichen Leiterstruktur- bzw. Leitbahnebenen angeordnet. Die gegebenenfalls durch Bildung leitfähiger Filamente bedrohte horizontale Isolation wird hierbei durch eine resistentere vertikale Isolation ersetzt. "Horizontal" bedeutet hierbei innerhalb einer Leiterstrukturebene, während "vertikal" senkrecht zu den jeweiligen Leiterstrukturebenen bedeutet. Dadurch kann die Resistenz bzw. Widerstandsfähigkeit gegenüber der Bildung von leitfähigen Filamenten durch zusätzliche Kunstharz-Glasfasergewebe-Schichten zu Lasten des Herstellungsaufwands sowie der Endhöhe/Stärke der Leiterkarte erhöht werden.

So ist es aus JP3076297 bekannt, zwischen zwei Leitbahnebenen bzw. -schichten mehrere Einzellagen kunstharzgetränkter Glasfasergewebematten (so genannte Prepregs) übereinander zu verarbeiten. Hierdurch wird die Wahrscheinlichkeit gesenkt, dass ein leitfähiges Filament von einer ersten Leitbahnebene zu einer zweiten Leitbahnebene durch das isolierende kunstharzgetränkte Glasfasergewebe entlang eines oder mehrerer Glasfaserabschnitte wächst.

Aus EP-A-1 653 789 ist eine Leiterplatte bekannt, die eine glasfaserverstärkte Kunststoffschicht umfasst, die eine Bohrung aufweist. In die Bohrung sind eine Blockierschicht und ein Leiter eingebracht.

Es ist Aufgabe der vorliegenden Erfindung, eine Leiterkarte zu schaffen, die eine hohe Widerstandsfähigkeit bzw. Resistenz gegen die Bildung leitfähiger Filamente (conductive anodic filaments, CAF) im Inneren, insbesondere auf ihren innen liegenden Schichten/Lagen, aufweist. Es ist ferner eine Aufgabe der vorliegenden Erfindung, ein Verfahren zum Erhöhen der Widerstandsfähigkeit einer Leiterkarte gegen eine Bildung von solchen leitfähigen Filamenten bereitzustellen. Die erfindungsgemässe Leiterkarte soll als Leiterkarte mit planaren Spulen und Transformatoren realisiert werden können.

Diese Aufgabe wird durch eine Leiterkarte mit den Merkmalen des Anspruchs 1 und durch ein Verfahren zum Erhöhen der Widerstandsfähigkeit einer Leiterkarte gegen eine Bildung von leitfähigen Filamenten mit den Merkmalen des Anspruchs 10 gelöst.

Die erfindungsgemässe Leiterkarte umfasst Leiterstrukturen und ein Gewebe aus Glasfasern, wobei wenigstens ein nichtleitendes bzw. isolierendes Blockierelement zum Blockieren des Wachstums eines leitfähigen Filaments entlang einer Glasfaser vorgesehen ist, die eine Leiterstruktur mit einer weiteren Leiterstruktur verbindet, und das Blockierelement die Glasfaser unterbricht. Unter einer Leiterkarte wird auch eine Leiterplatte bzw. eine Platine und ebenfalls ein Leiterkartenteil, -abschnitt bzw. -ausschnitt verstanden. Leiterstrukturen sind beispielsweise Leitbahnen und Leitbahnen verbindende Kontaktlöcher, die metallisiert sein können. Unter einer Glasfaser wird auch ein Glasfaserbündel verstanden. Das Gewebe aus Glasfasern kann auch als Matrix aus Glasfasern bezeichnet werden, wobei das Gewebe typischerweise durch Schuss- und Kettfäden aus Glasfasern gebildet wird.

Vorzugsweise wird das Blockierelement räumlich nahe einer Leiterstruktur angeordnet, die insbesondere gegenüber wenigstens einer weiteren Leiterstruktur elektrisch positives Potential hat.

Das Blockierelement weist ein Loch auf, das auch als Blockierloch bezeichnet werden kann, das insbesondere als Bohrloch ausgeführt ist, d.h. durch einen Bohrvorgang in der Leiterkarte erzeugt worden ist. Das Loch kann massiv ver- bzw. gefüllt sein. Das Loch ist nicht metallisiert.

Gemäss einem bevorzugten Ausführungsbeispiel der erfindungsgemässen Leiterkarte ist das Blockierelement als ein Loch bzw. Blockierloch ausgebildet, dessen Durchmesser grösser ist als der Durchmesser eines Kontaktlochs einer Leiterstruktur, der das Blockierelement zugeordnet ist. Hierdurch kann sichergestellt werden, dass das Loch das Wachstum eines leitfähigen Filaments entlang einer Glasfaser, das ausgehend von dem Kontaktloch wächst, blockiert.

Gemäss dem Ausführungsbeispiel der erfindungsgemässen Leiterkarte umfasst das Blockierelement mehrere beabstandet voneinander angeordnete Löcher bzw. Blockierlöcher, die in einer Tiefe bzw. Staffelungstiefe von wenigstens zwei Reihen zumindest teilweise um eine Leiterstruktur der Leiterkarte, beispielsweise um ein Kontaktloch herum, angeordnet sind. Bei diesem Ausführungsbeispiel sind die Löcher unterschiedlicher Reihen vorzugsweise versetzt angeordnet bzw. überlappen sich, sodass eine Glasfaser, die von der Leiterstruktur ausgeht, durch die Löcher unterbrochen ist. Der Durchmesser der Löcher kann dann kleiner oder gleich dem Durchmesser eines Kontaktlochs sein, um das Wachsen eines leitfähigen Filaments von einem Kontaktloch aus durch das Blockierelement zu blockieren.

Das erfindungsgemässe Verfahren zum Erhöhen der Widerstandsfähigkeit einer Leiterkarte gegen eine Bildung von leitfähigen Filamenten kennzeichnet sich dadurch aus, dass die Leiterkarte mit wenigstens einem Blockierelement versehen wird, das das Wachstum eines leitfähigen Filaments entlang einer Glasfaser blockiert, die eine Leiterstruktur mit einer weiteren Leiterstruktur verbindet, wobei das Blockierelement derart angeordnet ist, dass es die Glasfaser unterbricht. Die Leiterkarte wird dadurch mit einem Blockierelement versehen, dass wenigstens ein Loch, das auch als Blockierloch bezeichnet werden kann, in die Leiterkarte eingebracht wird, wobei das Loch bevorzugt durch Bohren in die Leiterkarte eingebracht wird. Das Loch kann massiv ver- bzw. gefüllt werden. Eine Metallisierung des Lochs erfolgt - anders als üblicherweise bei einem Kontaktloch - nicht.

Gemäss dem erfindungsgemässen Verfahren werden mehrere Löcher beabstandet voneinander in die Leiterkarte eingebracht, wobei die mehreren Löcher in einer Tiefe von wenigstens zwei Reihen zumindest teilweise um eine Leiterstruktur, beispielsweise um ein Kontaktloch herum, angeordnet werden. Die Löcher unterschiedlicher Reihe werden vorzugsweise versetzt bzw. überlappend angeordnet, sodass sichergestellt ist, dass eine Glasfaser, die von der Leiterstruktur ausgeht, bzw. ein sich entlang einer solchen Glasfaser bildendes Filament durch die Löcher unterbrochen wird.

Die Art, wie sich leitfähige Filamente (conductive anodic filaments, CAF) bilden, bedingt, dass sich leitfähige Filamente vor allem entlang von Glasfasern einer Leiterkarte bzw. des Leiterkartenmaterials ausbreiten bzw. wachsen. Versucht ein leitfähiges Filament sich dagegen von einer Glasfaser weg durch den massiven Kunstharz, in dem das Glasfasergewebe der Leiterkarte typischerweise getränkt ist, auszubreiten, so behindert dieser Kunstharz das weitere Wachstums des Filaments.

Mittels der erfindungsgemässen Lösung kann der direkte Bildungspfad leitfähiger Filamente entlang von Glasfasern blockiert werden, sodass die leitfähigen Filamente auf andere Glasfasern übergehen müssen, um weiter zu wachsen, hieran jedoch durch den zwischen den Glasfasern befindlichen Kunstharz behindert werden. Dies wird durch die in die Leiterkarte eingebrachten Blockierelemente erreicht, die vorzugsweise als ein oder mehrere Löcher in Form von Bohrlöchern ausgestaltet sind. Diese Blockierelemente unterbrechen wenigstens eine Glasfaser, die von einer Leiterstruktur auf einem bestimmten elektrischen Potential zu einer Leiterstruktur mit einem niedrigeren elektrischen Potential wächst, sodass ein leitfähiges Filament nicht weiter entlang dieser Glasfaser wachsen kann. Auf diese Weise können vorteilhafterweise kritische bzw. besonders gefährdete Leiterstrukturen, wie z.B. metallisierte Kontaktlöcher (Durchkontaktierungen) oder so genannte vergrabenen Durchkontaktierungen auf den innen liegenden Schichten/Lagen einer Leiterkarte, davor geschützt werden, dass von ihnen ausgehend, leitfähige Filamente zu einer Leiterstruktur auf einem niedrigeren elektrischen Potential wachsen. Als kritische bzw. besonders gefährdete Leiterstrukturen werden Leiterstrukturen angesehen, die besonders dazu geeignet sind, dass sich leitfähige Filamente von ihnen ausgehend bilden.

Insbesondere bei als Löchern ausgebildeten Blockierelementen kann die Widerstandsfähigkeit der Leiterkarte gegen die Bildung leitfähiger Filamente im Verhältnis zu der mechanischen Stabilität der Leiterkarte durch eine geeignete Wahl des Durchmessers und der Anzahl der Löcher optimiert werden. Die Blockierelemente gehen vorzugsweise nicht ineinander über und sind bevorzugt auch beabstandet von den Leiterstrukturen, insbesondere von den Kontaktlöchern der Leiterstrukturen angeordnet, was insbesondere bei einer Ausgestaltung der Blockierelemente als Löcher vorteilhaft für die mechanische Stabilität der Leiterkarte ist. Bei Blockierelementen, die als Löcher ausgestaltet sind, kann es zu einer geringen Erhöhung des oberflächigen Kriechweges kommen.

Die erfindungsgemässe Lösung kann vorteilhafterweise bereits in der Entwurfsphase einer Leiterkarte eingesetzt werden, sodass die erfindungsgemässe Lösung an den herkömmlichen Herstellungsprozess von Leiterkarten keine weiteren Anforderungen stellt bzw. die Einführung weiterer Prozessschritte bei der Herstellung nicht erforderlich ist. Der Entwerfer/Entwickler einer Leiterkarte kann die erfindungsmässe Lösung allein umsetzen. Die erfindungsgemässe Lösung ist ferner nicht herstellerabhängig und weist grundsätzlich keine Nachteile für auf einer Leiterkarte vorhandene konventionelle Schaltungsbestandteile auf.

Weitere vorteilhafte Ausgestaltungen der Erfindung ergeben sich aus den abhängigen Ansprüchen und den anhand der Zeichnungen nachfolgend dargestellten Ausführungsbeispielen. Es zeigen:
Fig. 1 eine schematische Darstellung eines Teilausschnitts einer Leiterkarte mit leitfähigen Filamenten,
Fig. 2 eine schematische Darstellung eines Teilausschnitts einer Leiterkarte, bei der die Leiterstrukturen in bekannter Weise derart angeordnet sind, dass die Bildung leitfähiger Filamente behindert wird,
Fig. 3 eine schematische Darstellung eines ersten Ausführungsbeispiels einer erfindungsgemässen Leiterkarte und
Fig. 4 eine schematische Darstellung eines zweiten Ausführungsbeispiels einer erfindungsgemässen Leiterkarte.

In den Figuren bezeichnen gleiche Bezugszeichen strukturell bzw. funktionell gleiche bzw. gleichwirkende Komponenten. Die Figuren 1 und 2 wurden bereits in der Beschreibungseinleitung beschrieben und es wird auf die dortigen Textstellen verwiesen.

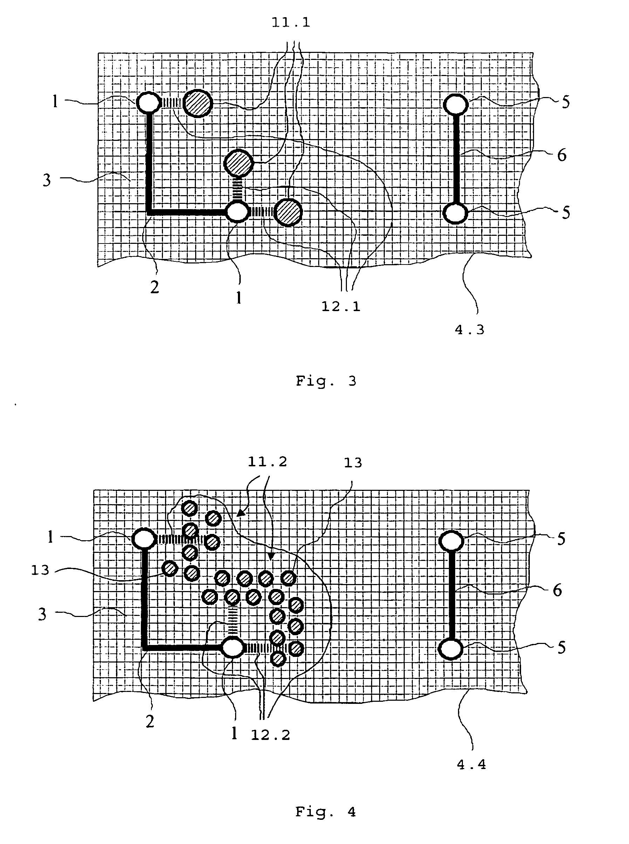

Fig. 3 zeigt ein erstes Ausführungsbeispiel 4.3 einer erfindungsgemässen Leiterkarte (bzw. von einem Teilausschnitt einer solchen) aus glasfaserverstärktem Kunstharz 3 (Kunstharz-Glaserfasergewebe bzw. Kunstharz-Glasfasermatrix), das bis auf die zusätzlichen Blockierelemente 11.1 und den Verlauf der leitfähigen Filamente 12.1 dem in Fig. 1 dargestellten Teilausschnitt 4.1 einer Leiterkarte entspricht. Es sind eine erste, nicht näher bezeichnete Leiterstruktur mit einer erste Leitbahn 2 und mit Kontaktlöchern 1 auf einem ersten elektrischen Potential und eine zweite, nicht näher bezeichnete Leiterstruktur mit einer zweite Leitbahn 6 und mit Kontaktlöchern 5 auf einem zweiten, niedrigeren elektrischen Potential vorgesehen. Die Glasfasern sind in Form eines Gewebes bzw. einer Matrix 3 angeordnet, die in Kunstharz getränkt ist, wobei das Glasfasergewebe typischerweise aus Glasfaser-Schuss- und Glasfaser-Kettfäden gebildet ist, was in den Figuren 1 bis 4 durch die karierte Darstellung der Leiterkarten 4.1 - 4.4 symbolisierst ist.

Bei der erfindungsgemässen Leiterkarte 4.3 sind ferner in der Nähe der ersten Leiterstruktur, insbesondere in der Nähe ihrer Kontaktlöcher 1, die beispielhaft als besonders gefährdete Leiterstrukturen angesehen werden, Blockierelemente 11.1 in Form von Löchern, insbesondere von Bohrlöchern, vorgesehen. Die Blockierelemente 11.1 sind in Richtung der nächstliegenden, zweiten Leiterstruktur mit der Leitbahn 6 und den Kontaktlöchern 5 angeordnet, die ein niedrigeres elektrisches Potential als die erste Leiterstruktur hat.

Jedem Kontaktloch 1 ist wenigstens ein Blockierelement 11.1 zugeordnet, wobei jedes Blockierelement 11.1 durch genau ein Loch gebildet wird, das einen grösseren Durchmesser aufweist, als das Kontaktloch 1, dem es zugeordnet ist. Auf diese Weise wird der direkte Bildungspfad eines leitfähigen Filaments 12.1 ausgehend von dem Kontaktloch 1 entlang einer Glasfaser, die in Richtung eines Schussfadens bzw. Kettfadens verläuft bzw. einen solchen bildet, unterbrochen und das leitfähige Filament 12.1 kann zumindest in dieser Richtung nicht weiter wachsen und zu einer Verbindung mit der Leitbahn 6 bzw. einem der Kontaktlöcher 5 und somit zu einem Zusammenbruch der Isolation zwischen der ersten Leiterstruktur und der zweiten Leiterstruktur führen.

Die Blockierelemente 11.1 sind vorzugsweise in Richtung der Schussfäden und/oder Kettfäden des Kunstharz-Glasfasergewebes 3 angeordnet, sodass in diesen Richtungen jeweils eine Unterbrechung einer Glasfaser erfolgt. Dem vom Betrachter aus gesehen unteren Kontaktloch 1 ist ein Blockierelement 11.1 in Richtung des Schussfadens und ein Blockierelement 11.1 in Richtung des Kettfadens des Kunstharz-Glasfasergewebes 3 zugeordnet. Dem vom Betrachter aus gesehen oberen Kontaktloch 1 braucht nur ein Blockierelement 11.1 in Richtung des Schussfadens zugeordnet zu werden, da oberhalb dieses Kontaktlochs keine weiteren Leiterstrukturen vorgesehen sind. So brauchen ausgehend von einer besonders gefährdeten Leiterstruktur in den Richtungen grundsätzlich keine Blockierelemente 11.1 vorgesehen zu sein, in denen einen weitere Leiterstruktur erst in einem grossen Abstand vorkommt.

Fig. 4 zeigt ein zweites Ausführungsbeispiel 4.4 einer erfindungsgemässen Leiterkarte (bzw. von einem Teilausschnitt einer solchen) aus glasfaserverstärktem Kunstharz 3 (Kunstharz-Glasfasergewebe bzw. Kunstharz-Glasfasermatrix), das bis auf die Ausgestaltung der Blockierelemente und den Verlauf der leitfähigen Filamente dem in Fig. 3 dargestellten Ausführungsbeispiel 4.3 entspricht.

Um jede bzw. in dem Umfeld von jeder als besonders gefährdet eingestuften Leiterstruktur, die sich auf einem gegenüber den weiteren Leiterstrukturen höheren Potential befindet, d.h. beispielhaft den Kontaktlöchern 1 der ersten Leiterstruktur, ist ein Blockierelement 11.2 angeordnet, das vorzugsweise einen von dem jeweiligen Kontaktloch 1 ausgehenden Schussfaden und einen von dem jeweiligen Kontaktloch 1 ausgehenden Kettfaden des Kunstharz-Glasfasergewebes 3 durchkreuzt und sich in Richtung auf die zweite Leiterstruktur mit der Leitbahn 6 und den Kontaktlöchern 5 erstreckt. Bei dem Blockierelement 11.2, das dem vom Betrachter aus gesehen weiter oben angeordneten Kontaktloch 1 zugeordnet ist, kann jedoch auf eine Kreuzung des durch dieses Kontaktloch 1 verlaufenden Kettfadens mittels des Blockierelements 11.2 verzichtet werden, da beispielhaft oberhalb dieses Kontaktlochs 1 keine weiteren Leiterstrukturen niedrigeren Potentials vorgesehen sind.

Jedes Blockierelement 11.2 umfasst mehrere beabstandet voneinander angeordnete Löcher 13, die das jeweilige Kontaktloch 1 beispielhaft in einer Staffelungstiefe von zwei Reihen umgeben, wobei die Reihen gekrümmt bzw. gebogen ausgestaltet sein können, sodass sie teilweise um das jeweilige Kontaktloch 5 herum verlaufen. Der Durchmesser der Löcher 13 ist kleiner oder gleich dem Durchmesser der Kontaktlöcher 1. Die Reihen der Löcher 13 überlappen dergestalt bzw. sind derart versetzt zueinander angeordnet, dass eine von einem Kontaktloch 1 in Richtung auf die zweite Leiterstruktur ausgehende Glasfaser durch die Löcher 13 unterbrochen wird.

Sind die Löcher 13 der Blockierelemente 11.2 so gewählt, dass sie untereinander den gleichen Durchmesser haben, so ist der Abstand der Mittelpunkte der in einer Reihe angeordneten Löcher 13 bevorzugt kleiner als der zweifache Durchmesser dieser Löcher 13.

Haben zumindest einige der Löcher 13, wenn nicht sogar sämtliche Löcher 13, verschiedene Durchmesser, so ist vorzugsweise der Abstand der Mittelpunkte der in einer Reihe angeordneten Löcher 13 kleiner als der zweifache Durchmesser des Lochs 13 mit dem grössten Durchmesser.

Durch die Blockierelemente 11.2 kann vorteilhafterweise der Bildungspfad leitfähiger Filamente 12.2 entlang von Glasfasern in Richtung auf eine weitere Leiterstruktur auf niedrigerem, elektrischen Potential unterbrochen werden.

## Patentansprüche

1. Leiterkarte umfassend Leiterstrukturen (1, 2, 5, 6) und ein Gewebe (3) aus Glasfasern, wobei wenigstens ein nichtleitendes Blockierelement (11.1; 11.2) zum Blockieren des Wachstums eines leitfähigen Filaments (12.1; 12.2) entlang einer Glasfaser vorgesehen ist, die eine Leiterstruktur (1, 2) mit einer weiteren Leiterstruktur (5, 6) verbindet, und das Blockierelement (11.1; 11.2) die Glasfaser unterbricht und wenigstens ein Loch (13) umfasst, **dadurch gekennzeichnet, dass** das Blockierelement (11.2) mehrere beabstandet voneinander angeordnete Löcher (13) umfasst, die in einer Tiefe von wenigstens zwei Reihen zumindest teilweise um eine Leiterstruktur (1) angeordnet sind.

2. Leiterkarte nach Anspruch 1, **dadurch gekennzeichnet, dass** das Blockierelement (11.1; 11.2) nahe einer Leiterstruktur (1, 2) angeordnet ist.

3. Leiterkarte nach Anspruch 2, **dadurch gekennzeichnet, dass** das Blockierelement (11.1; 11.2) nahe einer Leiterstruktur (1, 2) angeordnet ist, die gegenüber wenigstens einer weiteren Leiterstruktur (5, 6) elektrisch positives Potential aufweist.

4. Leiterkarte nach einem der vorhergehenden Ansprüche, **dadurch gekennzeichnet, dass** das Blockierelement (11.1; 11.2) als Loch ein Bohrloch umfasst.

5. Leiterkarte nach einem der vorhergehenden Ansprüche, **dadurch gekennzeichnet, dass** das wenigstens eine Loch (13) massiv verfüllt ist.

6. Leiterkarte nach einem der vorhergehenden Ansprüche, **dadurch gekennzeichnet, dass** die Löcher (13) unterschiedlicher Reihen derart versetzt angeordnet sind, dass eine Glasfaser durch die Löcher (13) unterbrochen ist.

7. Leiterkarte nach Anspruch 6, **dadurch gekennzeichnet, dass** der Durchmesser der Löcher (13) kleiner oder gleich dem Durchmesser eines Kontaktlochs (1) der Leiterstruktur (1, 2) ist.

8. Leiterkarte nach Anspruch 7, **dadurch gekennzeichnet, dass** die Löcher (13) den gleichen Durchmesser haben und dass der Abstand der Mittelpunkte der in einer Reihe angeordneten Löcher (13) kleiner ist als der zweifache Durchmesser dieser Löcher (13).

9. Leiterkarte nach Anspruch 7, **dadurch gekennzeichnet, dass** zumindest einige der Löcher (13) verschiedene Durchmesser haben und dass der Abstand der Mittelpunkte der in einer Reihe angeordneten Löcher (13) kleiner ist als der zweifache Durchmesser des Lochs (13) mit dem grössten Durchmesser.

10. Verfahren zum Erhöhen der Widerstandsfähigkeit einer Leiterkarte (4.3; 4.4) gegen eine Bildung von leitfähigen Filamenten (12.1; 12.2), wobei die Leiterkarte (4.3; 4.4) Leiterstrukturen (1, 2, 5, 6) und ein Gewebe (3) aus Glasfasern umfasst, wobei die Leiterkarte (4.3; 4.4) mit wenigstens einem nichtleitenden Blockierelement (11.1; 11.2) versehen wird, das das Wachstum eines leitfähigen Filaments (12.1; 12.2) entlang einer Glasfaser blockiert, die eine Leiterstruktur (1, 2) mit einer weiteren Leiterstruktur (5, 6) verbindet, wobei das Blockierelement (11.1; 11.2) derart angeordnet wird, dass es die Glasfaser unterbricht und die Leiterkarte (4.3; 4.4) dadurch mit einem Blockierelement (11.1; 11.2) versehen wird, dass wenigstens ein Loch (13) in die Leiterkarte (4.3; 4.4) eingebracht wird, **dadurch gekennzeichnet, dass** mehrere Löcher (13) beabstandet voneinander in die Leiterkarte (4.3; 4.4) eingebracht werden, wobei die mehreren Löcher (13) in einer Tiefe von wenigstens zwei Reihen zumindest teilweise um eine Leiterstruktur (1, 2, 5, 6) angeordnet werden.

11. Verfahren nach Anspruch 10, **dadurch gekennzeichnet, dass** das wenigstens eine Loch (13) durch Bohren in die Leiterkarte (4.3; 4.4) eingebracht wird.

12. Verfahren nach Anspruch 10 oder 11, **dadurch gekennzeichnet, dass** das wenigstens eine Loch (13) massiv verfüllt wird.

13. Verfahren nach einem der Ansprüche 10 bis 12, **dadurch gekennzeichnet, dass** die Löcher (13) unterschiedlicher Reihen versetzt angeordnet werden, sodass eine Glasfaser durch die Löcher (13) unterbrochen wird.

## Claims

1. Circuit board comprising conductor structures (1, 2, 5, 6) and a web (3) made of glass fibres, wherein at least one non-conductive blocking element (11.1; 11.2) for blocking the growth of a conductive filament (12.1; 12.2) along a glass fibre is provided, which connects a conductor structure (1, 2) to a further conductor structure (5, 6), and the blocking element (11.1; 11.2) interrupts the glass fibre and comprises at least one hole (13), **characterized in that** the blocking element (11.2) comprises several holes (13) that are arranged at a distance from each other, which are arranged at a depth of at least two rows at least partially around a conductor structure (1).

2. Circuit board according to claim 1, **characterized in that** the blocking element (11.1; 11.2) is arranged near a conductive structure (1, 2).

3. Circuit board according to claim 2, **characterized in that** the blocking element (11.1; 11.2) is arranged near a conductive structure (1, 2), which has an electrically positive potential with respect to at least one further conductor structure (5, 6).

4. Circuit board according to one of the preceding claims, **characterized in that** the blocking element (11.1; 11.2) comprises a bore hole as hole.

5. Circuit board according to one of the preceding claims, **characterized in that** the at least one hole (13) is compactly backfilled.

6. Circuit board according to one of the preceding claims, **characterized in that** the holes (13) of different rows are arranged offset in such a way that a glass fibre is interrupted by the holes (13).

7. Circuit board according to claim 6, **characterized in that** the diameter of the holes (13) is less than or equal to the diameter of a contact hole (1) of the conductor structure (1, 2).

8. Circuit board according to claim 7, **characterized in that** the holes (13) have the same diameter, and that the distance between the centres of the holes (13) that are arranged in a row is less than twice the diameter of these holes (13).

9. Circuit board according to claim 7, **characterized in that** at least some of the holes (13) have different diameters and that the distance between the centres of the holes (13) that are arranged in a row is less than twice the diameter of the hole (13) with the largest diameter.

10. Method for increasing resistivity of a circuit board (4.3; 4.4) to the formation of conductive filaments (12.1; 12.2), wherein the circuit board (4.3; 4.4) comprises conductor structures (1, 2, 5, 6) and a web (3) made of glass fibres, wherein the circuit board (4.3; 4.4) is provided with at least one non-conductive blocking element (11.1; 11.2), which blocks the growth of a conductive filament (12.1; 12.2) along a glass fibre, which connects a conductor structure (1, 2) to a further conductor structure (5, 6), wherein the blocking element (11.1; 11.2) is arranged in such a way that it interrupts the glass fibre and the circuit board (4.3; 4.4) is provided with a blocking element (11.1; 11.2) by inserting at least one hole (13) into the circuit board, **characterized in that** several holes (13) are inserted into the circuit board (4.3; 4.4) at a distance from each other, wherein the several holes (13) are arranged at a depth of at least two rows at least partially around a conductor structure (1, 2, 5, 6).

11. Method according to claim 10, **characterized in that** at least one hole (13) is inserted into the circuit board (4.3; 4.4) by boring.

12. Method according to claim 10 or 11, **characterized in that** at least one hole (13) is completely backfilled.

13. Method according to one of the claims 10 to 12, **characterized in that** the holes (13) of different rows are arranged offset, so that a glass fibre is interrupted by the holes (13).

## Revendications

1. Carte de circuits imprimés, comportant des structures conductrices (1, 2, 5, 6) et un tissu (3) en fibres de verre, sachant qu'il est prévu au moins un élément de blocage (11.1 ; 11.2) non conducteur pour bloquer la croissance d'un filament conducteur (12.1; 12.2) le long d'une fibre de verre, qui relie une structure conductrice (1, 2) à une autre structure conductrice (5, 6), et l'élément de blocage (11.1 ; 11.2) interrompt la fibre de verre et comporte au moins un trou (13), **caractérisée en ce que** l'élément de blocage (11.2) comporte plusieurs trous (13), qui sont disposés à distance les uns des autres et qui sont agencés au moins en partie autour d'une structure conductrice (1) sur une profondeur de deux rangs au moins.

2. Carte de circuits imprimés selon la revendication 1, **caractérisée en ce que** l'élément de blocage (11.1 ; 11.2) est agencé à proximité d'une structure conductrice (1, 2).

3. Carte de circuits imprimés selon la revendication 2, **caractérisée en ce que** l'élément de blocage (11.1 ; 11.2) est agencé à proximité d'une structure conductrice (1,2) qui, par rapport à au moins une autre structure conductrice (5, 6), possède un potentiel électriquement positif.

4. Carte de circuits imprimés selon l'une quelconque des revendications précédentes, **caractérisée en ce que** l'élément de blocage (11.1 ; 11.2) comporte une forure formant le trou.

5. Carte de circuits imprimés selon l'une quelconque des revendications précédentes, **caractérisée en ce que** ledit au moins un trou (13) est pleinement comblé.

6. Carte de circuits imprimés selon l'une quelconque des revendications précédentes, **caractérisée en ce que** les trous (13) de rangées différentes sont agencés en étant décalés de telle sorte qu'une fibre de verre est interrompue par les trous (13).

7. Carte de circuits imprimés selon la revendication 6, **caractérisée en ce que** le diamètre des trous (13) est inférieur ou égal au diamètre d'un trou de contact (1) de la structure conductrice (1, 2).

8. Carte de circuits imprimés selon la revendication 7, **caractérisée en ce que** les trous (13) ont le même diamètre et **en ce que** la distance entre les centres des trous (13) agencés dans une rangée est inférieure au double du diamètre de ces trous (13).

9. Carte de circuits imprimés selon la revendication 7, **caractérisée en ce qu'**au moins quelques trous (13) ont des diamètres différents et **en ce que** la distance entre les centres des trous (13) agencés dans une rangée est inférieure au double du diamètre du trou (13) avec le plus grand diamètre.

10. Procédé destiné à augmenter la résistance d'une carte de circuits imprimés (4.3 ; 4.4) à l'encontre de la formation de filaments conducteurs (12.1 ; 12.2), la carte de circuits imprimés (4.3 ; 4.4) comportant des structures conductrices (1, 2, 5, 6) et un tissu (3) en fibres de verre, la carte de circuits imprimés (4.3 ; 4.4) étant munie d'au moins un élément de blocage (11.1 ; 11.2) non conducteur, qui bloque la croissance d'un filament conducteur (12.1 ; 12.2) le long d'une fibre de verre, qui relie une structure conductrice (1,2) à une autre structure conductrice (5, 6), l'élément de blocage (11.1 ; 11.2) étant agencé de telle sorte qu'il interrompt la fibre de verre, et la carte de circuits imprimés (4.3 ; 4.4) étant munie d'un élément de blocage (11.1 ; 11.2) par le fait qu'au moins un trou (13) est ménagé dans la carte de circuits imprimés (4.3 ; 4.4), **caractérisé en ce que** plusieurs trous (13), disposés à distance les uns des autres, sont ménagés dans la carte de circuits imprimés (4.3 ; 4.4), la pluralité des trous (13) étant agencés au moins en partie autour d'une structure conductrice (1, 2, 5, 6) sur une profondeur de deux rangs au moins.

11. Procédé selon la revendication 10, **caractérisé en ce que** ledit au moins un trou (13) est ménagé par perçage dans la carte de circuits imprimés (4.3 ; 4.4).

12. Procédé selon la revendication 10 ou 11, **caractérisé en ce que** ledit au moins un trou (13) est pleinement comblé.

13. Procédé selon l'une quelconque des revendications 10 à 12, **caractérisé en ce que** les trous (13) de rangées différentes sont agencés en étant décalés de telle sorte qu'une fibre de verre est interrompue par les trous (13).
